## Europäisches Patentamt
## European Patent Office
## Office européen des brevets

(19)

(11) Publication number: **0 120 485**
**A2**

# (12) EUROPEAN PATENT APPLICATION

(21) Application number: **84103235.2**

(22) Date of filing: **23.03.84**

(51) Int. Cl.³: **G 11 C 8/00**

(30) Priority: **24.03.83 JP 49137/83**

(43) Date of publication of application:
**03.10.84 Bulletin 84/40**

(84) Designated Contracting States:
**DE FR GB IT**

(71) Applicant: **Kabushiki Kaisha Toshiba**
**72, Horikawa-cho Saiwai-ku**
**Kawasaki-shi Kanagawa-ken 210(JP)**

(72) Inventor: **Sueda, Akihiro**
**6-27-1-302, Kikuna**
**Kohoku-ku Yokohama-shi(JP)**

(74) Representative: **Lehn, Werner, Dipl.-Ing. et al,**
**Hoffmann, Eitle & Partner Patentanwälte Arabellastrasse**
**4 (Sternhaus)**
**D-8000 München 81(DE)**

(54) **Memory system.**

(57) There is provided a memory system whereby a memory cell array (32) is constituted by a plurality of memory cells (31) which is arranged in a matrix in the transverse and longitudinal directions. The memory cells (31) of one line which are arranged transversely in this memory cell array (32) are selected in parallel by a first row decoder (82). At least one memory cell among the memory cells (31) of one line which were selected by this first row decoder (82) is selected by a first column decoder (81), and the memory cells (31) of one line which are arranged longitudinally in said memory cell array (32) are selected in parallel by a second row decoder (83).

EP 0 120 485 A2

./...

Croydon Printing Company Ltd.

F I G. 5

- 1 -

Memory system

The present invention relates to a memory system, and more particularly to a static memory which accesses data of a plurality of bits in parallel, and which writes and reads the data.

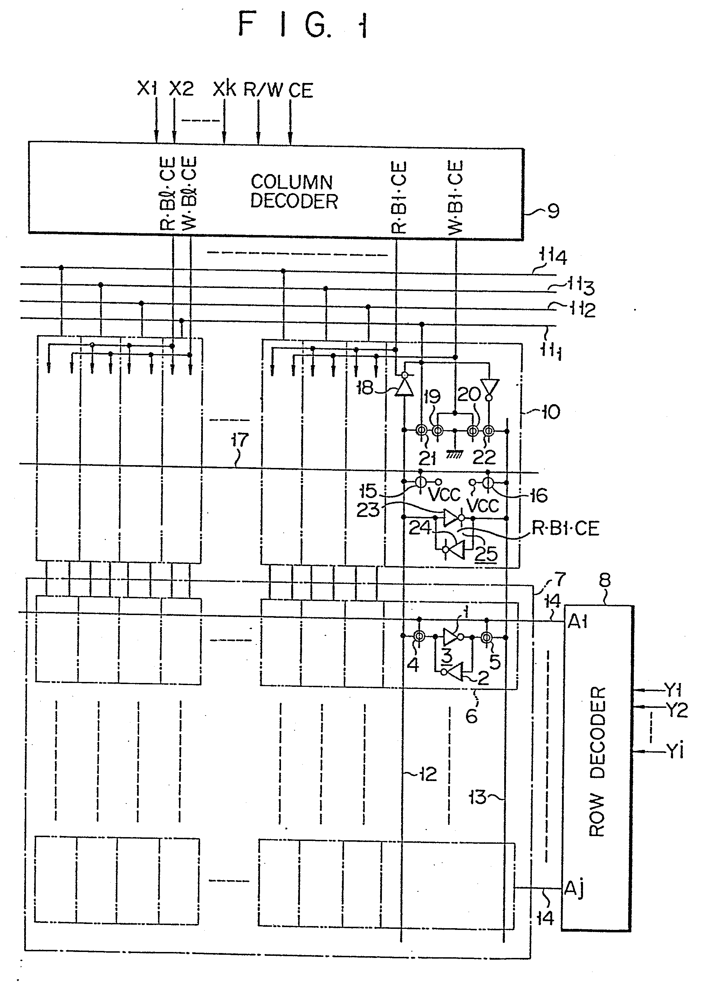

Fig. 1 shows a conventional static memory of the four-bit parallel processing type which writes or reads data of a plurality of bits, e.g., four-bit data in parallel. This memory is provided with a plurality of memory cells 6 for storing one-bit data, each of these memory cells having a flip-flop 3 consisting of two inverters 1 and 2 and two n-channel MOS FETs 4 and 5 for transferring data, respectively. The above-mentioned plurality of memory cells 6 is arranged in the transverse and longitudinal directions in a matrix, thereby constituting a memory cell array 7. The memory cells 6 corresponding to one line in the transverse direction of this memory cell array 7 are selected by a row decoder 8. The four memory cells 6 among the memory cells 6 of one line which are selected by the row decoder 8 are selected by a column decoder 9. Data is read out from or is written in the four memory cells 6 to be selected by this column decoder 9 by each of a plurality of input/output control circuits 10. The read data or write data are input/output through bus lines $11_1 - 11_4$ of four bits.

A plurality of memory cells 6 in each column is arranged in the longitudinal direction in the memory cell array 7, and is connected in parallel to each bit line pair 12 and 13. Similarly, the plurality of memory cells 6 for each line is arranged in the transverse direction and is connected in parallel to the corresponding plurality of word lines 14. The plurality of word lines 14 receives decoded output signals $A_1 - A_j$ from the row decoder 8; at least one of these decoded output signals $A_1 - A_j$ is set at "1" in response to the address signals $Y_1 - Y_i$ in the row direction. The column decoder 9 outputs two kinds of selection signals, $R \cdot B_1 \cdot CE - R \cdot B_\ell \cdot CE$ and $W \cdot B_1 \cdot CE - W \cdot B_\ell \cdot CE$, in response to the column direction address signal $X_1 - X_k$, a read/write control signal R/W, and a chip enable signal CE. When these memory cells are in the selection state (chip enable state) and when data is read out, one of the selection signals $R \cdot B_1 \cdot CE - R \cdot B_\ell \cdot CE$ is set at "1" in response to the column direction address signals $X_1 - X_k$. When these memory cells are in the selection state and when the data is written, one of the remaining selection signals $W \cdot B_1 \cdot CE - W \cdot B_\ell \cdot CE$ is set at "1" in response to the column direction address signals $X_1 - X_k$. Each of the two kinds of selection signals output from the column decoder 9 is supplied in parallel to each group of the input/output control circuits 10, wherein one group consists of the four I/O control circuits 10.

In a conventional memory as described above, before data is read out from or is written in the memory cells 6, two precharging p-channel MOSFETs 15 and 16, which are respectively provided in each input/output control circuit 10, are turned on in response to signals on a precharge control line 17. Due to this, each of the bit line pair 12 and 13 is precharged to "1" (level of a power voltage $V_{cc}$). Thereafter, in the data readout mode where the read/write control signal R/W has been set at "0", only one word line 14 is selected by the row decoder 8 which receives the row direction address signals $Y_1$ - $Y_j$, so that its signal A is set at "1". Next, the respective two MOSFETs 4 and 5 are turned on by a plurality of memory cells 6 in which one line is arranged transversely to the line which is connected to one of the selected word lines 14. The data is read out from each of the above-mentioned memory cells 6 to the bit line pair 12 and 13. Then, only one of the selection signals $R \cdot B_1 \cdot CE$ - $R \cdot B_\ell \cdot CE$ is set at "1" by the column decoder 9 which receives the column direction address signals $X_1$ - $X_k$. Due to this, clocked inverter 18, provided respectively in the four input/output control circuits 10 to which the one selection signal is being supplied in parallel, begin to operate. Thus, four (one group) memory cells 6 are selected. In these selected memory cells 6, the data which has been preliminarily read out by each one-bit line 12 is inverted by the clocked inverter 18 in the respective input/output control circuits 10, and is transmitted to the respective bus lines $11_1$ - $11_4$. The data of four bits is also read out in parallel by the same operation.

On the other hand, in the data write mode where the read/write control signal R/W was set at "1", only one of the selection signals $W \cdot B_1 \cdot CE$ - $W \cdot B_\ell \cdot CE$ is set at "1" by the column decoder 9. Due to this, two n-channel MOSFETs 19 and 20 provided in the four I/O control circuit 10 receive the one selection signal which is supplied in parallel, and are turned on. Thus, four (one group) memory cells 6 are selected. Furthermore, in the above-mentioned four I/O control circuits 10, only one of the n-channel MOSFETs 21 or 22 (which are inserted between the respective MOSFETs 19 and 20, and the respective bit line pair 12 and 13) is turned on in accordance with the write data of the respective bus lines $11_1$ - $11_4$. Thus, the data of the respective bus lines $11_1$ - $11_4$ is supplied through the respective bit line pair 12 and 13 to the above-mentioned four memory cells 6. Due to this, each memory cell 6 can write the data of the respective bit line pair 12 and 13. The data of four bits is also written in parallel by the same operation.

Two clocked inverters 23 and 24 provided in each I/O control circuit 10 respectively constitute a sense amplifier 25 for amplifying the data read out by respective bit line pair 12 and 13. The two clocked inverters 23 and 24 are controlled by the selection signals $R \cdot B_1 \cdot CE - R \cdot B_\ell \cdot CE$ so as to be synchronized with the clocked inverters 18.

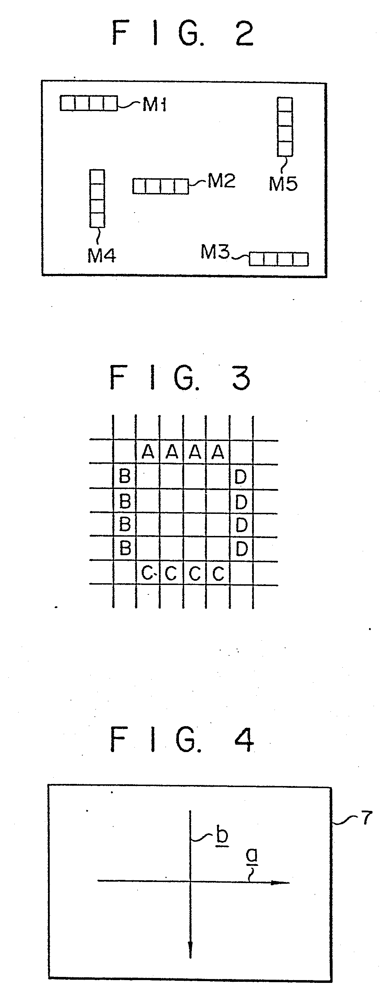

Fig. 2 shows an arrangement storage data in the memory cell array 7 of the memory of Fig. 1. In the memory of Fig. 1, the type of data having four bits which can be read out or written at a time is limited data which is arranged in the same direction (transverse direction in Fig. 2) as indicated by regions $M_1$, $M_2$, $M_3$, etc. in Fig. 2. This is because in a conventional memory, a plurality of memory cells 6 arranged transversely in a line is selected by the row decoder 8, and the four memory cells 6 among these memory cells are selected by the column decoder 9. Conventionally, as indicated by regions $M_4$, $M_5$, etc. in Fig. 2, it is impossible to directly access at a time a data group where the four-bit data is arranged longitudinally, i.e., in the direction perpendicular to the data arrangement direction of each of the above-mentioned regions $M_1$, $M_2$ and $M_3$. To obtain four-bit data which has a longitudinal arrangement, it is necessary to access the data four times in the transverse direction. That is, in spite of a memory which has four-bit parallel processing, one-bit processing is sometimes performed.

Further, sometimes, in the memory, the arrangement of a particular data group must be changed. For example, it is necessary in the case where the storage data constitutes a lattice image instead of a column or row image, as in television games, i.e., the case where the data, "A A A A", "B B B B", etc., of a plurality of bits to be accessed at a time is arranged in the transverse and longitudinal directions as shown in Fig. 3. In addition, it is also needed when storage data is directly used as the display data or as the data for a line printer. This corresponds to the case where the data is accessed in the direction of $a$ where it is written in the memory cell array 7, and where the data is accessed in the direction of $b$ perpendicular to the direction of $a$ where the data is read out as shown in Fig. 4.

Even in the cases mentioned above, it is conventionally necessary to read out the data a plurality of times; as a result, the process takes a long time.

According to the present invention, there is provided a memory system comprising a memory cell array constituted of a plurality of memory cells which is arranged in a matrix in first and second directions which cross each other, first selecting means for selecting in parallel the memory cells of one line which are arranged in the first direction in the memory cell array, and second selecting means for selecting at least one memory cell among the memory cells of one line which are selected in parallel by the first selecting means, data being written in or being read out from the memory cells selected by the second selecting means, wherein said memory system being characterized by further comprising third selecting means for selecting in parallel the memory cells of one line which are arranged in the second direction of the memory cell array.

This invention can be more fully understood from the following detailed description when taken in conjunction with the accompanying drawings, in which:

Fig. 1 shows a circuit diagram of a conventional static memory;

Fig. 2 is a diagram showing a storage state to describe the conventional memory;

Fig. 3 is a diagram showing a storage state to describe the conventional memory;

Fig. 4 is a diagram showing a memory cell array having different data access directions;

Fig. 5 shows a circuit diagram of a memory system according to one embodiment of the present invention;

Fig. 6 shows timing charts of the memory system of the above embodiment;

Figs. 7A and 7B show circuit diagrams of the memory system according to another embodiment of the present invention;

Fig. 8 is a circuit diagram showing the constitution of another memory cell; and

Fig. 9 is a circuit diagram showing the constitution of still another memory cell.

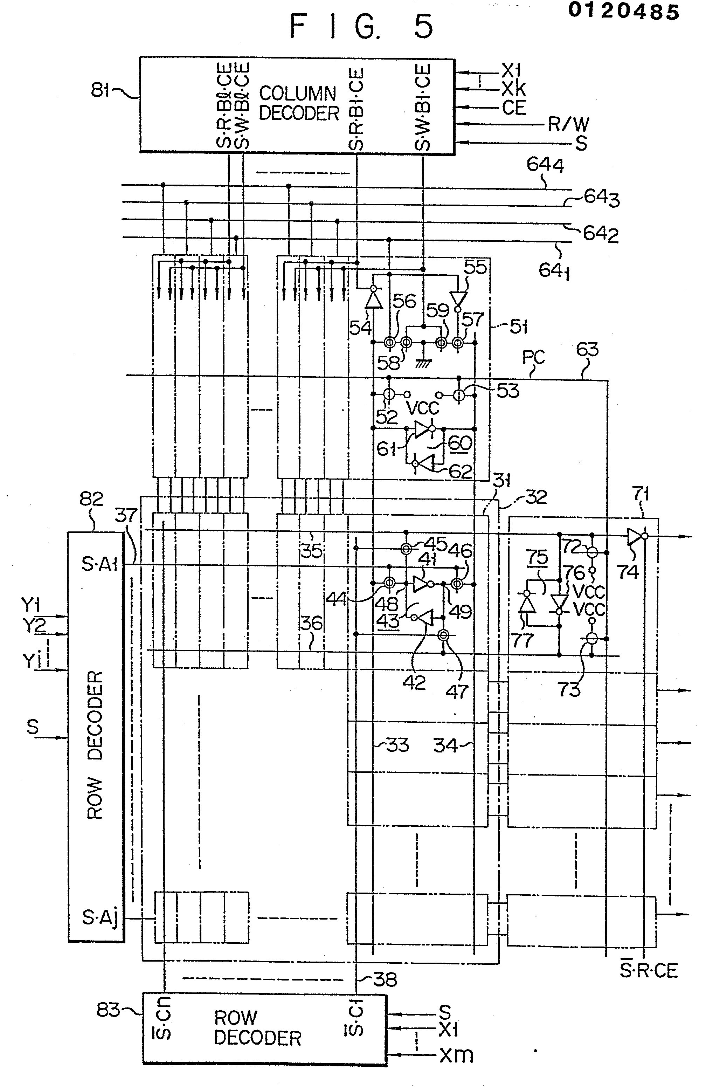

One embodiment of the present invention will next be described with reference to the drawings. Fig. 5 shows a circuit diagram of a memory system according to one embodiment of the present invention. In this memory system, a plurality of memory cells 31 each of which stores data of one bit is arranged in a matrix in the transverse and longitudinal directions, thereby constituting a memory cell array 32. In the memory cell array 32, each column of the plurality of memory cells 31 is arranged longitudinally to be parallel with the bit line pair 33 and 34 which extends in the longitudinal direction. Each row of the plurality of memory cells 31 is arranged transversely in the memory cell array 32 so that it is parallel to the second bit line pair 35 and 36 which extends in the transverse direction. Each row of the plurality of memory cells 31 which is arranged transversely in a line is connected in parallel to the corresponding first word lines 37 which extend in the transverse direction. Similarly, each column of the plurality of memory cells 31 which is arranged longitudinally in a line is connected in parallel to the corresponding second word lines 38 which extend in the longitudinal direction.

Each of the above-mentioned memory cells 31 consists of two inverters 41 and 42. The inverters are connected in such a manner that the output signal of one is used as the input signal of the other. The inverters 41, 42 are provided with a flip-flop 43 to store data of one bit, and with four n-channel MOSFETs 44 - 47 which serve as transfer gates for transferring data. One level of the one-bit data which is in a complementary relation is stored in each flip-flop 43. MOSFET 44 is inserted between a node 48 which connects the input terminal of the inverter 41 and the output terminal of the inverter 42, and each of the above-mentioned first bit lines 33. MOSFET 45 is inserted between the node 48, and each of the above-mentioned second bit lines 35. In each of the flip-flops 43, a level of the one-bit data which corresponds to the level mentioned above is stored. MOSFET 46 is inserted between a node 49 which connects the output terminal of the inverter 41 and the input terminal of the inverter 42, and each of the above-mentioned other first bit lines 34. MOSFET 47 is inserted between the node 49, and each of the above-mentioned other second bit lines 36. A signal from the corresponding first word line 37 is supplied in parallel to the gates of the two MOSFETs 44 and 46 in each memory cell 31. The signal from the corresponding second word line 38 is supplied in parallel to the gates of the other two MOSFETs 45 and 47. The first bit line pair 33 and 34 which extend longitudinally are connected to the input/output control circuits 51. Each input/output control circuit 51 comprises: two p-channel MOSFETs 52 and 53 for precharging the bit line pair 33 and 34; a clocked inverter 54 for transferring and controlling the data of from one bit line 33 to one of four bus lines which will be mentioned later; two n-channel MOSFETs 56 and 57 which are respectively turned on and off to obtain inversion data from the data from one of the four above-mentioned bus lines and from the output data from an inverter 55; two n-channel MOSFETs 58 and 59 which are respectively turned on and off in response to the selection signals output from a first column decoder which will be mentioned later; and two clocked inverters 61 and 62. Each input/output control circuit 51 also has a sense amplifier 60 which amplifies the data from the respective bit line pair 33 and 34.

Each of the two precharging MOSFETs 52 and 53 is inserted between the applying point of the power voltage $V_{cc}$, and each of the bit lines 33 and 34. A precharge control signal PC from a precharge control line 63 is supplied in parallel to their gates. The input terminal of the clocked inverter 54 is connected to the first one bit line 33, and the output terminal is connected to the corresponding bus line $64_1 - 64_4$. Each clocked inverter 54 which has been connected to an input/output control circuit 51 is controlled by one of selection signals $S \cdot R \cdot B_1 \cdot CE - S \cdot R \cdot B_\ell \cdot CE$ which are output from a first column decoder which will be discussed later. The above-mentioned respective two MOSFETs 56, 58 and 57, 59 are connected in series between each element of the first bit line pair 33 and 34, and the ground potential point. The data from the corresponding bus line 64 is supplied to the gate of the MOSFET 56, while the output data of the inverter 55 is supplied to the gate of the MOSFET 57. One of selection signals $S \cdot W \cdot B_1 \cdot CE - S \cdot W \cdot B_\ell \cdot CE$ output from the first column decoder (which will be mentioned later) is supplied to each gate of the respective MOSFETs 58 and 59 which are connected to the four input/output control circuits 51 as described earlier. The selection signals $S \cdot R \cdot B_1 \cdot CE - S \cdot R \cdot B_\ell \cdot CE$ control the two clocked inverters 61 and 62 which constitute the sense amplifier 60 and which are also located in each of the four I/O control circuits 51.

The second bit line pair 35 and 36 which extends in the transverse direction is connected to the corresponding output control circuit 71. Each output control circuit 71 is constituted by: two p-channel MOSFETs 72 and 73 for precharging the respective second bit line pair 35 and 36; a clocked inverter 74 for controlling the data transfer; and two clocked inverters 76 and 77. Each output control circuit 71 is also provided with a sense amplifier 75 for amplifying the data of the respective bit line pair 35 and 36. The two precharging MOSFETs 72 and 73 are respectively inserted between an applying point of the power voltage $V_{CC}$ and each of the bit lines 35 and 36. The precharge control signal PC mentioned before is supplied in parallel to their gates. The two clocked inverters 76 and 77 which constitute the sense amplifier 75 are inserted in the opposite directions between the bit line pair 35 and 36. The operation of the two clocked inverters 76 and 77, and of the clocked inverter 74 is controlled by signal $\overline{S} \cdot R \cdot CE$ to be formed by, for example, an AND gate.

To a first column decoder 81, the column address signals $X_1 - X_k$, the read/write control signal R/W, the chip enable signal CE, and the decoder selection signal S are supplied. When the decoder selection signal S is "1", the first column decoder 81 becomes operative, thereby setting both selection signals $S \cdot R \cdot B_1 \cdot CE - S \cdot R \cdot B_\ell \cdot CE$ and $S \cdot W \cdot B_1 \cdot CE - S \cdot W \cdot B_\ell \cdot CE$ to "1" in response to the combined column address signals $X_1 - X_k$, read/write control signal R/W, and chip enable signal CE. Both selection signals are then supplied in parallel to the input/output control circuits 51 of one group, which consists of the four I/O control circuits 51.

To a first row decoder 82, row address signals $Y_1 - Y_i$, and the decoder selection signal S are supplied. When the decoder selection signal S is at "1", this first row decoder 82 becomes operative, thereby outputting selection signals $S \cdot A_1$ – $S \cdot A_j$ to the plurality of first word lines 37 mentioned before. At least one of the selection signals $S \cdot A_1$ – $S \cdot A_j$ is set at "1" in response to the row address signals $Y_1$ – $Y_i$.

To a second row decoder 83, column address signals $Y_1$ – $X_m$ and the decoder selection signal S are supplied. When the decoder selection signal S is at "0", this second row decoder 83 becomes operative, thereby outputting selection signals $\overline{S} \cdot C_1$ – $\overline{S} \cdot C_n$ to the plurality of second word lines 38 mentioned before. Again, at least one of the selection signals $\overline{S} \cdot C_1$ – $\overline{S} \cdot C_n$ is set at "1" in response to the column address signals $X_1$ – $X_m$.

In a memory with such a constitution where the decoder selection signal S has been set at "1", the first column decoder 81 and the first row decoder 82 are made operative. Data is read out and is written in parallel for every four-bit memory cell 31 arranged in the transverse direction in a manner similar to a conventional memory. That is, before the data is read out or is written, the respective two MOSFETs 52 and 53 in the respective input/output control circuits 51 and turned on in response to the precharge control signal PC, so that the bit line pair 33 and 34 is precharged at "1".

When reading out data, only one of the first word lines 37 is selected by the row decoder 82, and only the signal $S \cdot A$ is set at "1". Then, the two MOSFETs 44, 46 of each of the memory cells, which are connected to the selected first word line 37, are turned on. Then, data which has been preliminarily stored in each of the memory cells 31 in the above-mentioned one line is read out in each of the first bit line pair 33 and 34. Next, one of the selection signals $S \cdot R \cdot B_1 \cdot CE$ – $S \cdot R \cdot B_\ell \cdot CE$ for one kind of column decoder 81 is set at "1", so that each sense amplifier 60 in the four input/output control circuits 51 is supplied in parallel and is made operative, and so that the data which was read out in each of the first bit line pair 33 and 34 is amplified by each sense amplifier 60. At the same time, each clocked inverter 54 inside the four I/O control circuits 51 is made operative, and transfers the data amplified by each of the sense amplifiers 60 to the respective bus lines $64_1$ - $64_4$. The data is read out in parallel from each of the four memory cells 31 arranged transversely in a line by a similar operation.

On the other hand, when writing data, one of the selection signals $S \cdot W \cdot B_1 \cdot CE$ - $S \cdot W \cdot B_\ell \cdot CE$ from column decoder 81 is set at "1". Thus, each of the two MOSFETs 58 and 59 inside the four input/output control circuits 51 where this selection signal which was set at "1" is supplied in parallel and is turned on. Due to this, four memory cells 31 from one line are selected. Furthermore, in the four I/O control circuits 51, only one of the two MOSFETs 56 and 57 is turned on in accordance with the write data of the respective bus lines $64_1$ - $64_4$. Consequently, data from the four groups of the bit line pair 33 and 34 corresponds to the data on the bus lines $64_1$ - $64_4$, and each of the four memory cells 31 writes the data of each bit line pair 33 and 34. The data of four bits are written in parallel by a similar operation.

After the data has been written for every four bits as described above, the decoder selection signal S is then set at "0". At this time only the second row decoder 83, not the first column decoder 81 and the first row decoder 82, is made operative. The data is read out for every line the memory cells 31 arranged longitudinally. That is, before reading out the data, the respective two MOSFETs, 72 and 73 in each output control circuit 71 are turned on responding to the precharge control signal PC, so that the second bit line pair 35 and 36 is precharged at "1". Thereafter, one of the second word lines 38 is selected by the second row decoder 83 and the remaining signal $\overline{S} \cdot C$ is set at "1". Due to this, the two MOSFETs 45 and 47 in a plurality of memory cells 31 which are connected in parallel to one of the second word lines 38 selected and which are arranged longitudinally in a line are turned on. Consequently, the data which has been preliminarily stored in each memory cell 31 of the above-mentioned longitudinal line is read out in each of the second bit line pair 35 and 36. At the same time, the sense amplifiers 75 of the output control circuit 71 respond to the signals $\overline{S} \cdot R \cdot CE$ which are synchronized with the chip enable signal CE, and the data which is read out from each of the second bit line pair 35 and 36 is amplified by each of these sense amplifiers 75. The clocked inverters 74 in all of the output control circuits 71 are made operative, and the data which was amplified by the sense amplifiers 75 is output through the respective clocked inverters 74. The data can be read out in parallel from all of the memory cells 31 arranged longitudinally in a line in the memory cell array 32 by a similar operation.

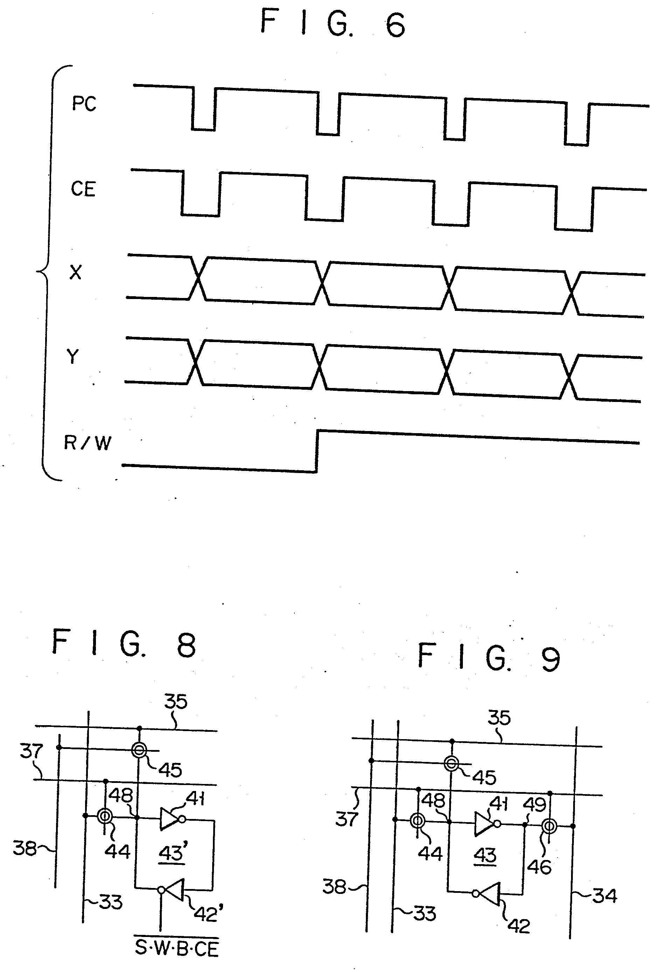

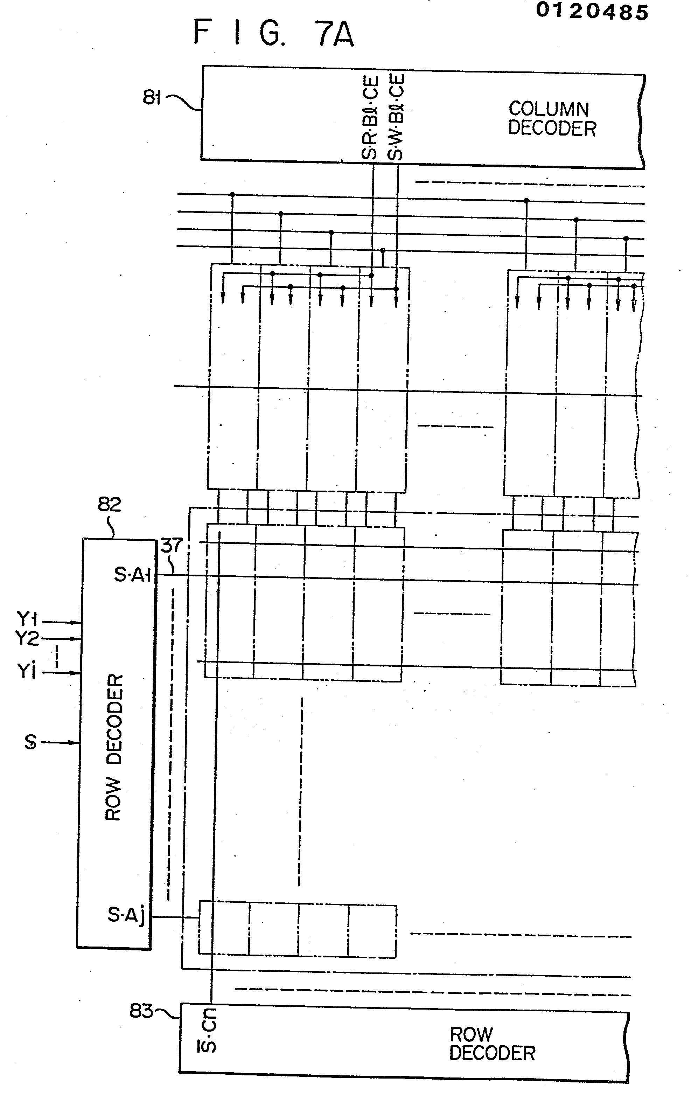

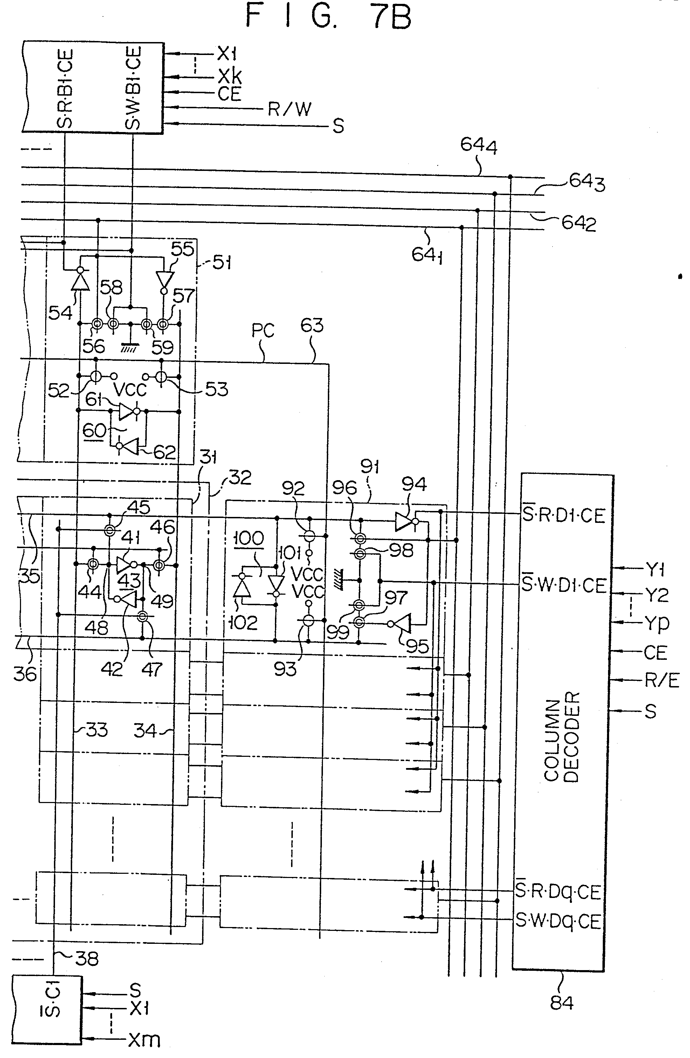

The timing charts of Fig. 6 shows the relations among the respective signals PC, CE, R/W, the column address signals X, and the row address signals Y in the memory system of this embodiment.

As described above, in the memory system of this embodiment, it is of course possible to read the data from and to write the data in the four memory cells 31 which are arranged transversely in a line in parallel as in a conventional memory system; furthermore, it is also possible to read out the data in parallel from all of the memory cells which are arranged longitudinally in a line. When reading data from the memory cells which are arranged longitudinally in a line, it is necessary to access the data a plurality of times with respect to the transverse direction in a conventional memory system. However, in the memory system of this embodiment, since the second row decoder 83 is provided, it is possible to select in parallel a plurality of memory cells arranged longitudinally in a line. Due to this, the access time for reading data from a plurality of memory cells arranged longitudinally in a line can be equal to or shorter than the time needed to read data from memory cells arranged transversely.

Figs. 7A and 7B show circuit diagrams of a memory system according to another embodiment of the present invention. In the memory system of the embodiment of Fig. 5, data is written in parallel in the four-bit memory cells which are arranged transversely in a line in the memory cell array, at the same time that data is read out from the four-bit memory cell which are arranged transversely in a line or from all of the memory cells arranged longitudinally in a line. However, in the memory system of this embodiment, data can be read out and written in parallel for every four-bit memory cell in both the transverse and longitudinal directions. Namely, in the memory system of this embodiment, an input/output control circuit 91 which is similar to the input/output control circuits 51 replaces the output control circuit 71 in the memory system of Fig. 5, and further a second column decoder 84 is added.

Each input/output control circuit 91 comprises: the MOSFETs 52, 53, 56, 57, 58, and 59 (as in the previously-mentioned input/output control circuits 51); the sense amplifier 60 consisting of the two clocked inverters 61 and 62; MOSFETs 92, 93, 96, 97, 98, and 99 corresponding to the clocked inverters 54 and 55; a sense amplifier 100 consisting of two clocked inverters 101 and 102; a clocked inverter 94; and an inverter 95.

Each of the second bit line pair 35 and 36 which extends transversely in the memory cell array 32 is connected to the corresponding input/output control circuits 91. The input terminal of the clocked inverter 94 of each I/O control circuit 91 is connected to each second bit line 35, while the output terminal is connected to one of the four bus lines $64_1$ - $64_4$. The operation of each of the clocked inverters 94 is controlled in response to one of the selection signals $\overline{S} \cdot R \cdot D_1 \cdot CE$ - $\overline{S} \cdot R \cdot D_q \cdot CE$ which is output from the second column decoder 84. In addition, data on the corresponding bus line 64 is supplied to the gate of the MOSFET 96, and the output data of the inverter 95 is supplied to the gate of the MOSFET 97. One of the selection signals $\overline{S} \cdot W \cdot D_1 \cdot CE$ - $\overline{S} \cdot W \cdot D_q \cdot CE$ output from the second column decoder 84 is supplied in parallel to the gates of the MOSFETs 98 and 99. The selection signal which is supplied to the MOSFETs 98 and 99 is supplied to the two clocked inverters 101 and 102 which constitute the sense amplifier 100.

To the second column decoder 84, the row address signals $Y_1$ - $Y_p$, the read/write control signal R/W, the chip enable signal CE, and the decoder selection signal S are supplied. When the decoder selection signal S is at "0", the decoder 84 performs the decoding operation. This second column decoder 84 sets each selection signal, $\overline{S} \cdot R \cdot D_1 \cdot CE$ - $\overline{S} \cdot R \cdot D_q \cdot CE$ and $\overline{S} \cdot W \cdot D_1 \cdot CE$ - $\overline{S} \cdot W \cdot D_q \cdot CE$, at "1". These two selection signals are supplied in parallel to the I/O control circuits 91 of each group, wherein one group consists of four I/O control circuits 91, respectively.

In a memory system having such a constitution, to read or to write the data in memory cells 31 of four bits which are arranged transversely in the memory cell array 32, the decoder selection signal S is set at "1". Due to this, as in the memory system of fig. 5, the first column decoder 81 and the first row decoder 82 are made operative, respectively, and the data is read out and is written in parallel for every memory cell 31 of four bits which is arranged transversely in a line in the memory cell array 32.

On the other hand, to read or to write the data in memory cells 31 which are arranged longitudinally in the memory cell array 32, the decoder selection signal S is set at "0". At this time, the second row decoder 83 and the second column decoder 84 are made operative. Before data is read out from or is written in the memory cells 31 which are arranged longitudinally in the memory cell array 32, the two MOSFETs 92 and 93 in each I/O control circuit 91 are turned on in response to the precharge control signal PC, and all of the second bit line pairs 35 and 36 are precharged at "1". Thereafter, in order to read data, one of the second word lines 38 is selected by the second row decoder 83 and the remaining selection signal $\overline{S} \cdot C$ is set at "1". A plurality of memory cells 31 which is connected in parallel to the above-mentioned one second word line 38 which is arranged longitudinally in a line in the memory cell array 32 is selected. The two MOSFETs 45 and 47 are turned on in each of these memory cells 31. Due to this, the data which has been stored in the nodes 48 and 49 of each of the memory cells 31 is read in the respective second bit line pair 35 and 36. Then, one of the selection signals $\overline{S} \cdot R \cdot D_1 \cdot CE - \overline{S} \cdot R \cdot D_q \cdot CE$ from the second column decoder 84 is set at "1", and the clocked inverter 94 in each I/O control circuit 91 of each group consisting of four I/O control circuits to which this signal which was set at "1" is supplied in parallel and is made operative, thereby selecting the four memory cells 31. Thus, the data is read out from these selected four memory cells 31 in the respective one bit line 35, is amplified by the sense amplifier 100, and then is transferred to the respective bus lines $64_1 - 64_4$ through the clocked inverters 94. The data of four bits is read out in parallel from the four memory cells 31 arranged longitudinally in a line in the memory cell array 32 by a similar operation.

However, to write data, after the memory cells 31 of one longitudinal line have been selected by the second row decoder 83, the two MOSFETs 98 and 99 (which are respectively provided in the four I/O control circuits 91) respond to the selection signals $\overline{S} \cdot W \cdot D_1 \cdot CE - \overline{S} \cdot W \cdot D_q \cdot CE$ from the second column decoder 84, so that four memory cells 31 from the line arranged longitudinally are selected. Furthermore, the respective two MOSFETS 96 and 97 in the four I/O control circuits 91 are turned on or off in accordance with the write data and inversion data of the respective bus lines $64_1 - 64_4$. Due to this, data corresponding to the data of the respective bus lines $64_1 - 64_4$ is supplied to the four memory cells 31 through the respective second bit line pair 35 and 36, and the data of four bits is written in parallel in the four memory cells 31 arranged longitudinally.

In addition, to write the data, the decoder selection signal S is set at "1" to make the first column decoder 81 and the first row decoder 82 operative, thereby writing the data in every four memory cells arranged transversely in the memory cell array 32. When reading out the data, the decoder selection signal S is set at "0". This makes the second row decoder 83 and the second column decoder 84 operative, and enables the data to be read out from every four memory cells arranged longitudinally in the memory cell array 32. Furthermore, by changing the setting method of the decoder selection signal S, it is also possible to write the data in every four memory cells arranged longitudinally, and to read the data from every four memory cells arranged transversely.

In the memory system of this embodiment, the access time needed to read and to write data in the four memory cells which are arranged in mutually different directions can be made equal to each other.

In the memory system of this embodiment, the number of memory cells 31 used when data is read out or when it is written in both the transverse and the longitudinal directions is always four. However, this number is not limited to four, and it is not always necessary to set them to be equal to each other.

Moreover, the present invention is not limited to the embodiments described above, various modifications are possible. For example, in the memory system of Fig. 5, there has been described the case where one memory cell 31 is constituted by the flip-flop 43, four MOSFETs 44, 45, 46, and 47 for controlling the data transfer, the first bit line pair 33 and 34, and the second bit line pair 35 and 36. However, this memory cell may be constituted such as shown in Fig. 8 or 9. Namely, in the memory cell of Fig. 8, in place of the flip-flop 43, there is used the flip-flop 43' in which the inverter 41 and the clocked inverter 42' of the C-MOS type are connected in the opposite directions. The clocked inverter 42' is provided with a controlling MOSFET in which a selection signal $\overline{S \cdot W \cdot B \cdot CE}$ is supplied to only the n-channel MOSFET side. In addition, only one of the first and second bit lines 33 and 35 is provided. Data is transferred and controlled among the node 48 and the bit lines 33 and 35 through the MOSFETs 44 and 45.

In the memory cell of Fig. 9, the other bit line 36 between the second bit line pair 35 and 36 is removed. Therefore, the MOSFET 47 for controlling data transfer connected to this bit line 36 is also removed. In addition, in the case of adopting the memory cells of Figs. 8 and 9, it is also necessary to change the respective constitutions of the input/output control circuits 51, and the output control circuits 71. For instance, in the case of the memory cell of Fig. 8, one MOSFET may be used for precharging.

As described above, the memory system according to the present invention enables data groups arranged in mutually different directions in the memory cell array to be equally accessible.

Claims:

1. A memory system comprising:

a memory cell array (32) constituted by a plurality of memory cells (31) which is arranged in a matrix in first and second directions which cross each other;

first selecting means (82) for selecting a plurality of memory cells (31) which is arranged in said first direction in said memory cell array (32); and

second selecting means (81) for selecting at least one memory cell among the memory cells (31) which are selected by said first selecting means (82);

data being written in or being read out from the memory cells selected by said second selecting means (81),

whereby said memory system being characterized by further comprising third selecting means (83) for selecting a plurality of memory cells (31) which is arranged in said second direction in said memory cell array (32).

2. A memory system comprising:

a memory cell array (32) constituted by a plurality of memory cells (31) which is arranged in a matrix in first and second directions which cross each other;

first selecting means (82) for selecting a plurality of memory cells (31) which is arranged in said first direction in said memory cell array (32); and

second selecting means (81) for selecting at least one memory cell among the memory cells (31) which are selected by said first selecting means (82),

data being written in or being read out from the memory cells (31) selected by said second selecting means (81),

whereby said memory system being characterized by further comprising

third selecting means (83) for selecting a plurality of memory cells (31) which is arranged in said second direction in said memory cell array (32); and

fourth selecting means (84) for selecting at least one memory cell among the memory cells (31) which are selected by said third selecting means (83).

3. A memory system comprising:

a memory cell array (32) constituted by a plurality of memory cells (31) which is arranged in a matrix in first and second directions which cross each other;

first selecting means (82) for selecting in parallel the memory cells (31) of one line which are arranged in said first direction in said memory cell array (32); and

second selecting means (81) for selecting at least one memory cell among the memory cells (31) of one line which are selected in parallel by said first selecting means (82),

data being written in or being read out from the memory cells selected by said second selecting means (81),

whereby said memory system being characterized by further comprising third selecting means (83) for selecting in parallel the memory cells (31) of one line which are arranged in said second direction in said memory cell array (32).

4. A memory system comprising:

a memory cell array (32) constituted by a plurality of memory cells (31) which is arranged in a matrix in first and second directions which cross each other;

first selecting means (82) for selecting in parallel the memory cells (31) of one line which are arranged in said first direction in said memory cell array (32); and

second selecting means (81) for selecting at least one memory cell among the memory cells (31) of one line which are selected in parallel by said first selecting means (82),

data being written in or being read out from the memory cells (31) selected by said second selecting means (81),

whereby said memory system being characterized by further comprsing

third selecting means (83) for selecting in parallel the memory cells (31) of one line which are arranged in said second direction in said memory cell array (32), and

fourth selecting means (84) for selecting at least one memory cell among the memory cells (31) of one line which are selected in parallel by said third selecting means (83).

5. A memory system according to claim 3, characterized in that only one of said first selecting means (82) and said third selecting means (83) is made operative in response to a control signal (S).

6. A memory system according to claim 4, characterized in that only one of said first selecting means (82) and said third selecting means (83) and only one of said second selecting means (81) and said fourth selecting means (84) are respectively made operative in response to said control signal (S).

7. A memory system according to claim 3, characterized in that said second selecting means (81) selects in parallel two or more memory cells among the memory cells (31) of said one line.

8. A memory system according to claim 4, characterized in that said fourth selecting means (84) selects in parallel two or more memory celles among the memory cells (31) of said one line.

9. A memory system according to claim 4, characterized in that each of said second selecting means (81) and said fourth selecting means (84) selects in parallel the same number of memory cells among the memory cells (31) of said respective one line.

10. A memory system according to claim 3, characterized in that each of said memory cells (31) which constitute said memory cell array (32) consists of:

data storing means (43) for storing the data in data storage nodes (48, 49);

a first control line (37) to which one selection signal (S·A) to be output from said first selecting means (82) is supplied;

a second control line (38) to which one selection signal ($\overline{S}$·C) to be output from said third selecting means (83) is supplied;

first and second data transfer lines (33, 34, 35, 36) to which the data is transferred;

first switch means (44, 46) inserted among said data storage nodes (48, 49) of said data storing means (43) and said first data transfer lines (33, 34), the conductivity of said first switch means (44, 46) being controlled in response to said signal (S·A) on said first control line (37); and

second switch means (45, 47) inserted among said data storage nodes (48, 49) of said data storing means (43) and said second data transfer lines (35, 36), the conductivity of said second switch means (45, 47) being controlled in response to said signal ($\overline{S}$·C) on said second control line (38).

11. A memory system according to claim 4, characterized by further comprising means (71) for reading out the data from each of the memory cells (31) of one line which are selected by said third selecting means (83).

12. A memory system according to claim 4, characterized by further comprising means (91) for writing the data in and reading the data from the memory cells (31) which are selected by said fourth selecting means (84).

13. A memory system according to claim 10, characterized by further comprising precharge means (52, 53, 92, 93) for precharging said first and second data transfer lines (33, 34, 35, 36) into a predetermined potential ($V_{CC}$).

F I G. 1

# FIG. 2

# FIG. 3

# FIG. 4

F I G. 5

3/6

0120485

# F I G. 6

# F I G. 8

$\overline{S \cdot W \cdot B \cdot CE}$

# F I G. 9

# F I G. 7A

FIG. 7B

6/6

0120485